# EUROPÄISCHE PATENTSCHRIFT

(11) **EP 2 878 054 B1**
(45) Veröffentlichungstag und Bekanntmachung des Hinweises auf die Patenterteilung: **11.09.2019**
(21) Anmeldenummer: 13744434.5
(22) Anmeldetag: 25.07.2013
(51) Int. Cl.: H02B 1/052, H02B 1/20

(54) **MONTAGESYSTEM FÜR DIE ANORDNUNG VON BEISPIELSWEISE ELEKTRISCHEN EINRICHTUNGEN INSBESONDERE IN SCHALTSCHRÄNKEN**
ASSEMBLY SYSTEM FOR THE MOUNTING OF E.G. ELECTRICAL APPLIANCES ESPECIALLY IN ELECTRICAL CABINETS
SYSTÈME DE MONTAGE POUR PAR EXEMPLE DES ÉQUIPEMENTS ÉLECTRIQUES EN PARTICULIER DANS DES ARMOIRES ÉLECTRIQUES

(30) Priorität: 25.07.2012 DE 102012014975
(43) Veröffentlichungstag der Anmeldung: 03.06.2015
(73) Patentinhaber: Friedrich Lütze GmbH, 71366 Weinstadt-Gro Heppach (DE)
(72) Erfinder: LÜTZE, Udo, 71394 Kernen-Stetten (DE); LANG, Jürgen, 71640 Ludwigsburg (DE); ERKER, Hubert, 73333 Gingen (DE); GHIZELEA, Virgil, 70372 Stuttgart (DE)
(74) Vertreter: Bartels und Partner, Patentanwälte
(86) Internationale Anmeldenummer: PCT/EP2013/002208
(87) Internationale Veröffentlichungsnummer: WO 2014/015986

(56) Entgegenhaltungen:
- EP-A2- 1 465 307
- DE-A1- 2 330 166
- DE-A1- 2 758 782
- DE-U1- 20 301 265

## Beschreibung

Die Erfindung betrifft ein Montagesystem für die Anordnung von beispielsweise elektrischen Einrichtungen, insbesondere in Schaltschränken, mit den Merkmalen im Oberbegriff von Anspruch 1.

In der industriellen Steuerungstechnik werden elektrische Geräte häufig in Schaltschränken oder Schaltkästen angeordnet. Die einzelnen Einrichtungen werden auf Tragschienen wie beispielsweise einer Hutschiene angeordnet und können aneinander gereiht werden. Anschließend werden die Einrichtungen verdrahtet, wobei ein kammartiges Ordnungsmittel an dem die Tragschiene aufweisenden Montagesteg angebracht ist, um die Verbindungsleitungen der Einrichtungen zu ordnen. Ein zugehöriges Montagesystem wird von der Anmelderin Friedrich Lütze GmbH in 71384 Weinstadt angeboten und ist beispielsweise auch aus der DE 203 01 265 U1 bekannt.

Die DE 43 23 370 A1 zeigt eine Profilleiste aus Isolierstoff zum Halten einer Vielzahl von elektrischen Leitungen.

Die DE 10 2008 060 843 B3 zeigt Umlenkmodule für Kabel, die an einem vertikalen Rahmenschenkel eines Rahmengestells eines Schaltschrankes anschraubbar sind.

Die DE 27 58 782 A1 beschreibt ein Montagesystem für die Anordnung von beispielsweise elektrischen Einrichtungen insbesondere in Schaltschränken, wobei das Montagesystem mindestens einen vorzugsweise horizontal verlaufenden Montagesteg aufweist, an dem mindestens eine Einrichtung anbringbar ist, wobei das Montagesystem ein mit dem Montagesteg verbindbares Ordnungsmittel aufweist zum Ordnen der Verbindungsleitungen der an dem Montagesteg anzubringenden Einrichtung, wobei das Ordnungsmittel entlang der Längsrichtung des Montagesteges eine Vielzahl miteinander verbundener oder aneinander anliegender Ordnungssegmente aufweist und wobei aus dem Ordnungsmittel wahlweise einzelne oder mehrere Ordnungssegmente lösbar und von dem Ordnungsmittel unter Zurücklassen einer Lücke in dem Ordnungsmittel entfernbar sind.

Weitere Montagesysteme gehen aus der DE 23 30 166 A1 und der EP 1 465 307 A2 der Schutzrechtsinhaberin hervor.

Der vorliegenden Erfindung liegt die Aufgabe zugrunde, ein neues Montagesystem bereitzustellen, das verbesserte Gebrauchseigenschaften aufweist, insbesondere vielseitig einsetzbar ist und dabei dennoch einfach in der Handhabung und Montage ist. In einer Ausführungsart soll insbesondere die Ordnung der Verbindungsleitungen weiter verbessert werden und insbesondere das Montagesystem eine weiter verbesserte Flexibilität bieten. Die Aufgabe ist durch das im Anspruch 1 bestimmte Montagesystem gelöst. Besondere Ausführungsarten der Erfindung sind in den Unteransprüchen bestimmt.

Gemäß dem Kennzeichen von Anspruch 1 ist vorgesehen, dass das Montagesystem unterschiedliche Ordnungssegmente für unterschiedliche Abmessungen der zu ordnenden Verbindungsleitungen aufweist, die vorzugsweise eine übereinstimmende Länge aufweisen, und dass die unterschiedlichen Ordnungssegmente entlang des Montagesteges wahlfrei aneinander anreihbar sind.

Dadurch können unterschiedliche Ordnungssegmente, für unterschiedliche Abmessungen der zu ordnenden Verbindungsleitungen, wahlweise an die geeignete Stelle eingesetzt werden. Dies kann insbesondere auch noch vor Ort an der Einsatzstelle des Montagesystems erfolgen, beispielsweise nachdem die Position der anzubringenden Einrichtung mit ihren spezifischen Verbindungsleitungen gewählt ist. Für die Vorbereitung der Montage ist es vorteilhaft, dass die Ordnungssegmente im Ausgangszustand miteinander verbunden sind, so dass auf einfache Weise ein größerer Abschnitt oder vorzugsweise die gesamte Länge des Montagesteges mit dem Ordnungsmittel bestückt werden kann.

In einer Ausführungsart weist das Montagesystem mindestens einen, vorzugsweise horizontal verlaufenden Montagesteg auf, an dem eine oder mehrere Einrichtungen anbringbar sind. Das Montagesystem weist weiterhin ein mit dem Montagesteg verbindbares Ordnungsmittel auf zum Ordnen der Verbindungsleitungen der an dem Montagesteg anzubringenden Einrichtung. Der Montagesteg kann beispielsweise aus einem Profil gebildet sein, und insbesondere aus Aluminium oder einer aluminiumhaltigen Legierung hergestellt sein. Der Montagesteg kann einstückig eine Aufnahmeeinrichtung für das anzubringende Ordnungsmittel aufweisen. Das Ordnungsmittel kann aus einem elektrisch isolierenden Werkstoff hergestellt sein, insbesondere aus einem Kunststoff.

Das Ordnungsmittel weist entlang der Längsrichtung des Montagesteges eine Vielzahl von in einem Ausgangszustand des Montagesteges miteinander verbundenen oder aneinander anliegenden Ordnungssegmenten auf, die vorzugsweise identisch ausgebildet sind und/oder eine übereinstimmende Länge aufweisen. Aus dem Ordnungsmittel sind wahlweise einzelne oder mehrere Ordnungssegmente einfach, vorzugsweise manuell und dabei gegebenenfalls auch unter Verwendung eines Werkzeuges, lösbar und anschließend von dem Ordnungsmittel unter Zurücklassen einer Lücke in dem Ordnungsmittel entfernbar oder gegen ein anderes Ordnungssegment vorzugsweise übereinstimmender Länge unter Schließen der Lücke austauschbar.

Dabei ist es vorteilhaft, wenn mindestens ein Teil der einzelnen Ordnungssegmente des Montagesystems, insbesondere die für einen Austausch vorgesehenen oder freigegebenen Ordnungssegmente, eine vorgebbare Maximallänge von beispielsweise weniger als 150 mm, insbesondere weniger als 100 mm und vorzugsweise weniger als 80 mm, nicht überschreiten, weil dadurch die Lösbarkeit und Austauschbarkeit aus dem Verbund der an dem Montagesteg angeordneten Ordnungssegmente relativ einfach möglich ist, insbesondere manuell oder mit einem einfachen Werkzeug und geringem Kraftaufwand, und vorzugsweise ohne das benachbarte Ordnungssegmente aus ihrer am Montagesteg festgelegten Position gelöst werden müssen.

Bei dem Montagesystem können ein oder mehrere Montagestege an einer Trageinrichtung festlegbar sein, beispielsweise an rechtwinklig zu den Montagestegen und vorzugsweise vertikal verlaufenden Profilstäben. Die Profilstäbe können zusammen mit den Montagestegen einen Montagerahmen bilden, der vormontierbar ist und anschließend am Einsatzort beispielsweise in einen Schaltschrank einsetzbar ist.

Das Ordnungssegment kann kammartig ausgebildet sein mit schräg oder quer zur Längsrichtung des Ordnungssegments, die mit der Längsrichtung des Montagesteges zusammenfallen kann, von einem stegförmigen und insbesondere geradlinigen Festlegeabschnitt abstehenden Ordnungselementen, zwischen denen Verbindungsleitungen einführbar und dadurch in mindestens einer Richtung fixierbar sind.

In einer Ausführungsart weisen die Ordnungselemente an beiden axialen Enden Verkettungsmittel auf, mittels denen ein Ordnungssegment mit einem daran in Längsrichtung anschließenden weiteren Ordnungssegment verkettbar ist. Beispielsweise kann jedes Ordnungssegment an einem ersten axialen Ende einstückig einen rechtwinklig zur Längsachse verlaufenden und insbesondere runden oder vieleckigen Zylinder aufweisen und an seinem gegenüberliegenden zweiten axialen Ende eine entsprechend geformte Zylinderaufnahme, in welche das erste axiale Ende des benachbarten Ordnungssegments einführbar ist.

Im verketteten Zustand fluchten die Festlegeabschnitte der Ordnungssegmente miteinander, um auf diese Weise einfach in die Aufnahmeeinrichtung des Montagesteges einführbar zu sein. In einer Ausführungsart ist die Zylinderachse der Verkettungselemente parallel zur Einsteckrichtung der Ordnungssegmente in die Aufnahmeeinrichtung des Montagesteges, so dass die Ordnungssegmente auch im an dem Montagesteg festgelegten Zustand des Ordnungsmittels einfach und vorzugsweise werkzeuglos lösbar und abnehmbar sind. In die dadurch entstehende Lücke ist bei Bedarf ein anderes, insbesondere ein anders ausgestaltetes Ordnungssegment einsetzbar.

In einer Ausführungsart ist die Verkettung der Ordnungssegmente lösbar, insbesondere durch eine Relativbewegung der beiden miteinander verketteten Ordnungssegmente schräg und insbesondere quer zur Längsrichtung der Ordnungssegmente lösbar. Die Relativbewegung zum Lösen kann auch parallel zu der Einsteckrichtung des Ordnungssegments in die Aufnahmeeinrichtung des Montagesteges verlaufen.

In einer Ausführungsart bildet das Ordnungsmittel in einem Ausgangszustand die aneinander angereihten Ordnungssegmente einstückig aus. Das Ordnungsmittel weist vorzugsweise äquidistante und die einzelnen Ordnungssegmente begrenzende Solltrennstellen auf. Diese Solltrennstellen können entweder werkzeuglos oder mittels eines einfachen Werkzeugs, beispielsweise einer Schneidklinge, aufgetrennt werden und anschließend kann das vereinzelte Ordnungssegment oder eine Gruppe abgetrennter Ordnungssegmente herausgelöst werden.

In einer Ausführungsart sind die Solltrennstellen in einem Festlegeabschnitt des Ordnungsmittels angeordnet, mittels dem das Ordnungsmittel an dem Montagesteg festlegbar ist. Die Solltrennstellen können vorzugsweise zwischen zwei benachbarten Ordnungselementen angeordnet sein, so dass eine Trennung benachbarter Ordnungssegmente mit geringen Kräften möglich ist, insbesondere keine Ordnungselemente durchtrennt werden müssen.

In einer Ausführungsart weisen die Ordnungssegmente vorzugsweise mittig in Bezug auf ihre Längserstreckung eine Werkzeugangriffsfläche auf, an der ein Werkzeug zum Lösen eines mit dem Montagesteg verbundenen Ordnungssegments ansetzbar ist. Vorzugsweise ist die Aussparung im Festlegeabschnitt der Ordnungssegmente angeordnet, insbesondere nahe dem Übergang des Festlegeabschnitts zu den Ordnungselementen des Ordnungssegments. Beispielsweise kann die Werkzeugangriffsfläche durch eine schräg und insbesondere quer zur Längsrichtung des Ordnungssegments verlaufende Nut in dem Festlegeabschnitt gebildet sein, wobei ein Ende der Nut auch noch im mit dem Montagesteg verbundenen Zustand des Ordnungssegments für das Werkzeug, beispielsweise einen Schlitzschraubendreher, zugänglich ist.

In einer Ausführungsart weist das Montagesystem mehrere Ordnungssegmente auf, die sich zwar hinsichtlich der Ordnungselemente unterscheiden, aber hinsichtlich ihres Festlegeabschnitts zum Festlegen an dem Montagesteg und gegebenenfalls hinsichtlich ihrer Verkettungsmittel oder ihrer Solltrennstellen übereinstimmen. Beispielsweise bildet eines der Ordnungssegmente eine sich vorzugsweise über die gesamte Länge des Ordnungssegments erstreckende Aufnahmekammer für die zu ordnende Verbindungsleitung. Ein dem Montagesteg bzw. dem Festlegeabschnitt des Ordnungssegments gegenüberliegender Schenkel des Ordnungssegments ist auslenkbar und dadurch ist die zu ordnende Verbindungsleitung in die Aufnahmekammer einführbar. Auf diese Weise können auch besonders große oder mehrere kleinere Verbindungsleitungen, beispielsweise auch pneumatische oder faseroptische Verbindungsleitungen, mit diesem Ordnungssegment geordnet werden.

In einer Ausführungsart weist das Montagesystem ein Ordnungssegment mit einem schräg und insbesondere quer zur Längsrichtung vorspringenden Halteabschnitt auf zum Anbringen eines Haltemittels für die Verbindungsleitung, beispielsweise eines Kabelbinders. Der Halteabschnitt kann dabei auch schräg und insbesondere quer zu den Ordnungselementen des Ordnungssegments vorspringen, beispielsweise in Richtung auf eine Vorderseite des Montagesteges, an der die Tragschiene angeordnet ist, so dass der Halteabschnitt des Ordnungssegments von der Vorderseite des Montagesteges zugänglich ist.

In einer Ausführungsart weist mindestens ein Teil der Ordnungssegmente, vorzugsweise alle Ordnungssegmente, eine übereinstimmende Länge von weniger als 150 mm auf, insbesondere weniger als 100 mm und vorzugsweise weniger als 80 mm. Daneben kann das Montagesystem auch Ordnungssegmente mit einer Länge von beispielsweise 150 mm oder 300 mm aufweisen, insbesondere solche, die nicht vom Montagesteg aus dem Verbund der dort festgelegten Ordnungssegmente lösbar sein sollen. Die Länge der einzelnen Ordnungssegmente kann an die verwendete Länge der Montagestege derart angepasst sein, dass ein ganzzahliges Vielfaches der Länge der Ordnungssegmente die Länge des Montagesteges ergibt. In einer Ausführungsart ist insbesondere eine übereinstimmende Länge der Ordnungssegmente von 50 mm besonders vorteilhaft, weil dadurch die üblichen Längen der Montagestege ohne Platzverlust oder manuelles Ablängen der Ordnungssegmente zusammensetzbar sind.

Das Montagesystem kann auch Ordnungssegmente aufweisen, die ein Vielfaches der Länge eines Grund-Ordnungssegments aufweisen, beispielsweise Ordnungssegmente mit einer Länge von 100 mm, 150 mm oder 300 mm gegenüber einem Grund-Ordnungssegment mit einer Länge von 50 mm.

Bei den an dem Montagesteg festlegbaren Einrichtungen kann es sich beispielsweise um elektrische Einrichtungen handeln, etwa Stromversorgungen, Sicherungen, Steuerungen, Ein-/Ausgabe-Baugruppen, Schnittstelleneinheiten, Temperaturwandler, Analog/Digital-Wandler oder dergleichen. Alternativ oder ergänzend kann die Vorrichtung auch nicht-elektrische Komponenten aufweisen, beispielsweise optische Komponenten oder pneumatische Komponenten.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt eine perspektivische Ansicht auf ein Ausführungsbeispiel eines Montagesystems;
- Fig. 2: zeigt einen Montagesteg in vergrößerter Darstellung;
- Fig. 3: zeigt ein Ausführungsbeispiel eines ersten Ordnungsmittels;
- Fig. 4: zeigt eine perspektivische Ansicht auf einen Montagesteg mit einem eingesetzten Ordnungsmittel;
- Fig. 5: zeigt den Montagesteg der Fig. 4 mit einem ausgetauschten Ordnungssegment;
- Fig. 6: zeigt eine Ansicht auf ein weiteres Ordnungssegment;
- Fig. 7: zeigt einen Schnitt durch einen Montagesteg mit dem daran festgelegten Ordnungssegment der Fig. 6;
- Fig. 8: zeigt in vergrößerter Darstellung einen Ausschnitt aus der Fig. 7;
- Fig. 9: zeigt eine Ansicht auf ein weiteres Ordnungssegment;
- Fig. 10: zeigt einen Schnitt durch einen Montagesteg mit dem daran festgelegten Ordnungssegment der Fig. 9;
- Fig. 11: zeigt in vergrößerter Darstellung einen Ausschnitt aus der Fig.10;
- Fig. 12: zeigt eine Ansicht auf eine weitere Komponente;
- Fig. 13: zeigt einen Schnitt durch einen Montagesteg mit der daran festgelegten weiteren Komponente der Fig. 12;
- Fig. 14: zeigt in vergrößerter Darstellung einen Ausschnitt aus der Fig. 13;
- Fig. 15: zeigt eine Seitenansicht auf einen Montagesteg nach dem Stand der Technik;
- Fig. 16: zeigt eine Seitenansicht auf eine Schalttafel nach dem Stand der Technik;
- Fig. 17: zeigt eine Seitenansicht auf ein Beispiel eines Montagesteges während des Anbringens einer Einrichtung;
- Fig. 18: zeigt eine Seitenansicht auf ein Beispiel eines Montagesteges mit daran angebrachter Einrichtung;
- Fig. 19: zeigt eine perspektivische Ansicht auf einen Montagesteg;
- Fig. 20: zeigt eine Seitenansicht auf den Montagesteg der Fig. 19;
- Fig. 21: zeigt einen Ausschnitt aus der Fig. 20 in vergrößerter Darstellung;
- Fig. 22: zeigt eine perspektivische Ansicht auf ein Ende des Montagesteges;
- Fig. 23: zeigt eine Seitenansicht auf den Montagesteg der Fig. 22;
- Fig. 24: zeigt einen Ausschnitt aus der Fig. 23 in vergrößerter Darstellung;
- Fig. 25: zeigt eine perspektivische Ansicht auf die Rückseite des Montagesystems der Fig. 1;
- Fig. 26: zeigt eine Seitenansicht auf einen Montagesteg der Fig. 25;
- Fig. 27: zeigt eine Seitenansicht auf einen Montagesteg mit einem auf die Raststege aufgerasteten Adapterelement;
- Fig. 28: zeigt eine perspektivische Ansicht auf die Rückseite des Montagesteges mit zwei aufgerasteten Adapterelementen;
- Fig. 29: zeigt eine zweite weitere Komponente des Montagesystems;
- Fig. 30: zeigt eine Seitenansicht des Montagesteges mit einem auf der Rückseite mittels Adapterelementen befestigten Kabelkanal;
- Fig. 31: zeigt eine perspektivische Ansicht auf ein weiteres Beispiel eines Montagesystems;
- Fig. 32: zeigt eine Seitenansicht auf ein weiteres Beispiel eines Montagesteges ohne Tragschiene; und
- Fig. 33: zeigt eine Seitenansicht auf ein weiteres Beispiel eines unsymmetrischen Montagesteges.

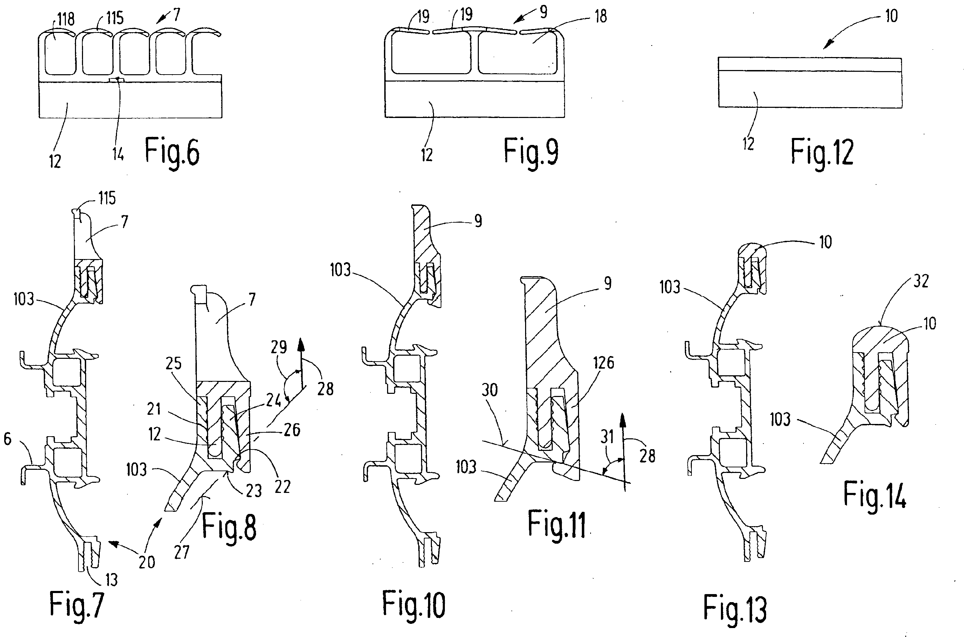

Die Fig. 13-33 dienen lediglich der Erläuterung des Hintergrundes der Erfindung und sind nicht Gegenstand eines Anspruches.

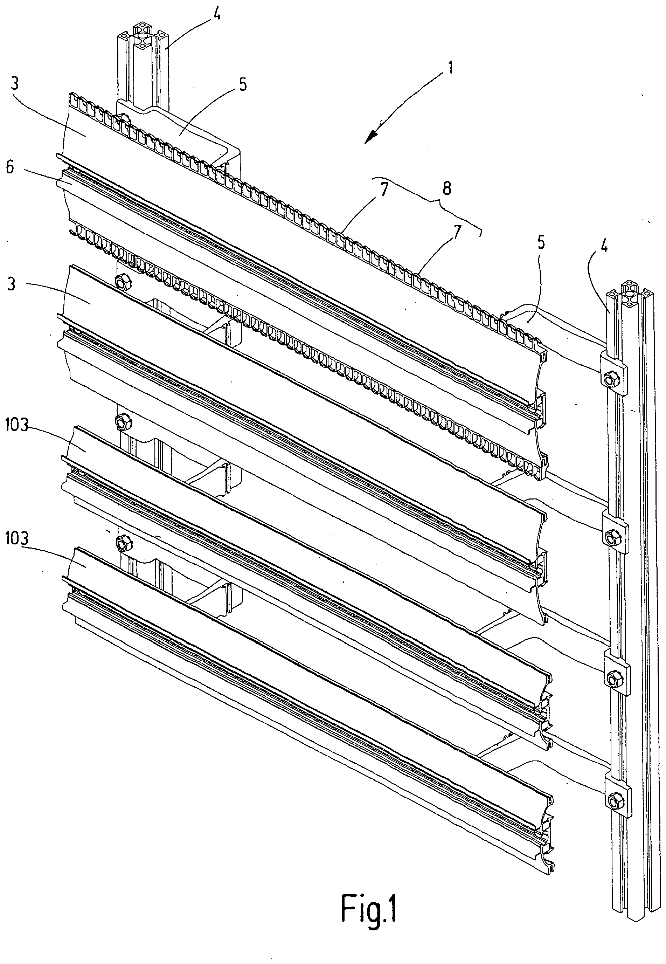

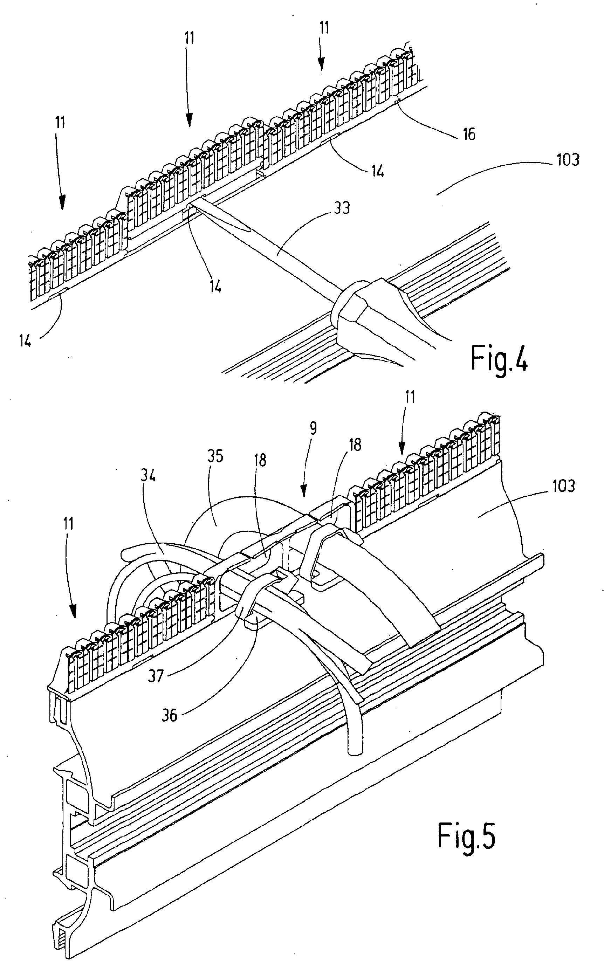

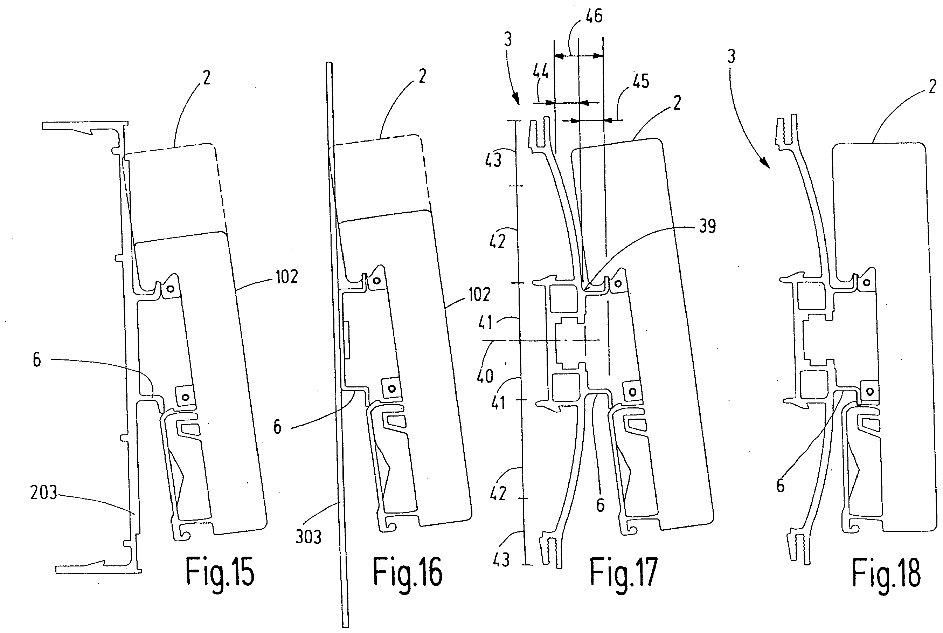

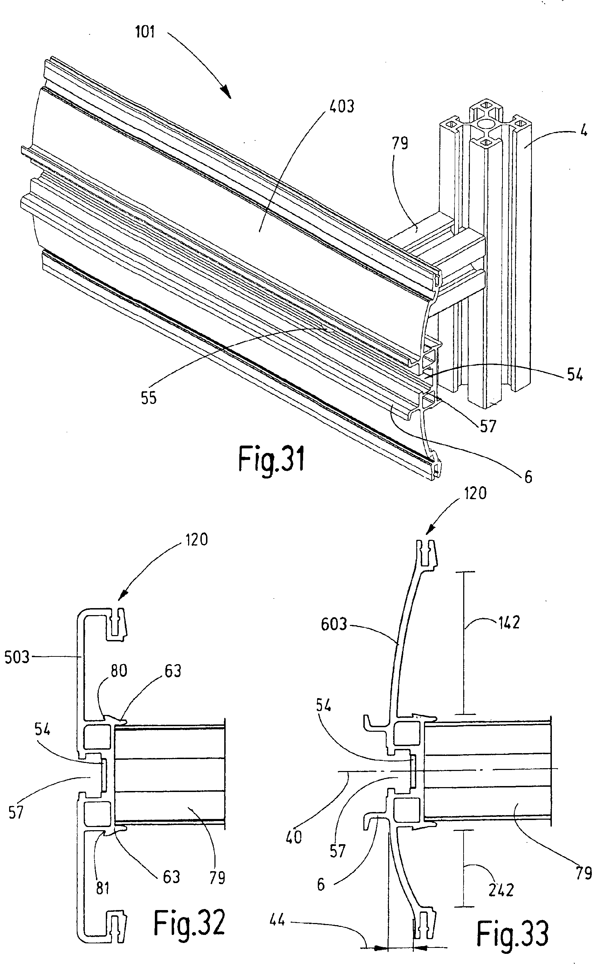

Die Figur 1 zeigt eine perspektivische Ansicht auf ein Ausführungsbeispiel eines Montagesystems 1, das insgesamt vier horizontal verlaufende Montagestege 3, 103 aufweist, an denen jeweils mindestens eine Einrichtung 2 (Fig. 17) anbringbar ist. Die beiden unteren Montagestege 103 weisen eine geringere laterale Erstreckung auf gegenüber den beiden oberen Montagestegen 3. Die Montagestege 3, 103 sind an oder nahe ihren beiden Enden, beispielsweise bis 200 mm und insbesondere bis 125 mm von ihren beiden Enden entfernt, mittels jeweils eines Montagebügels 5 oder einem sonstigen Verbindungselement 79 (Fig. 31) mit jeweils einem vertikal verlaufenden Profilstab 4 verbunden und bilden zusammen mit den Profilstäben 4 einen Montagerahmen, der vormontierbar ist und anschließend in dem in der Fig. 1 dargestellten Zustand oder auch mit bereits daran angebrachten Einrichtungen 2 und deren Verbindungsleitungen 34, 35 (Fig. 5) in einen Schaltschrank einsetzbar ist. Die Montagestege 3, 103 weisen jeweils eine Tragschiene 6 auf, an welcher die Einrichtungen 2 anzubringen sind, im Ausführungsbeispiel eine genormte oder eine einer Norm im Wesentlichen entsprechenden Hutschiene mit einer Höhe der Hutschiene von 7,5 mm.

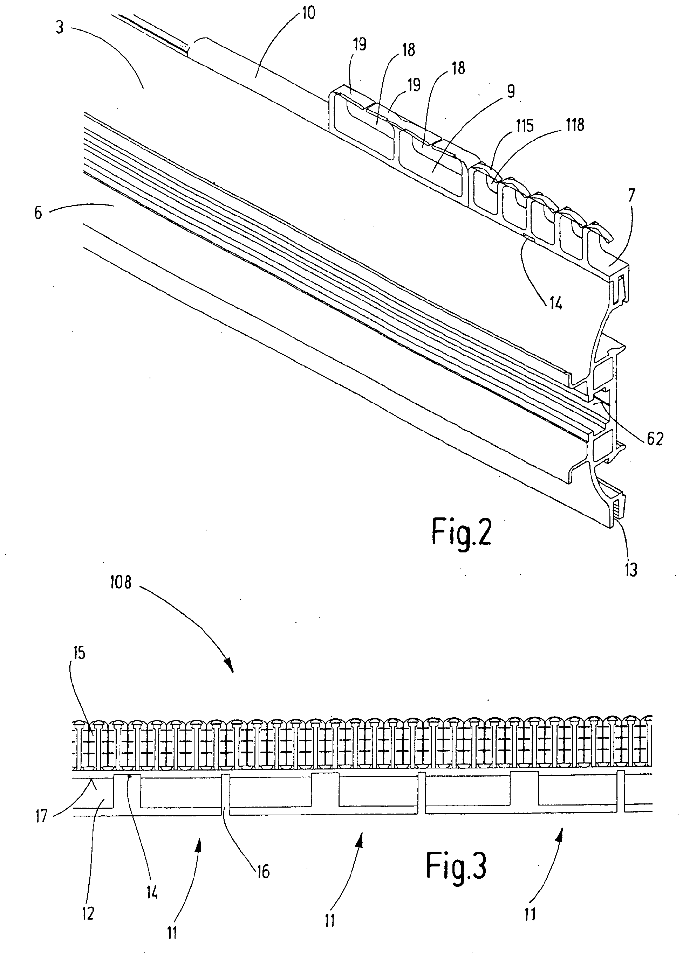

An den Längsrändern des in der Fig. 1 oberen Montagesteges 3 ist jeweils ein Ordnungsmittel 8 angebracht, das aus einer Vielzahl gleichartig ausgebildeter Ordnungssegmente 7 zusammengesetzt ist. Aus dem Ordnungsmittel 8 sind wahlweise einzelne oder mehrere Ordnungssegmente 7 lösbar und von dem Ordnungsmittel 8 bzw. dem Montagesteg 3 unter Zurücklassen einer Lücke entfernbar oder gegen ein anderes Ordnungssegment 9 (Fig. 2), 11 (Fig. 3) oder eine Gruppe von anderen Ordnungssegmenten 9, 11 austauschbar.

Die Fig. 2 zeigt einen Montagesteg 3 in vergrößerter Darstellung. Die Fig. 3 zeigt ein Ordnungsmittel 108, das durch eine Vielzahl einstückig ausgebildeter und hintereinander angeordneter Ordnungssegmente 11 zusammengesetzt ist. Anstelle der einstückigen Ausbildung können die Ordnungssegmente 11 auch an ihren Enden jeweils Verkettungsmittel aufweisen, mittels denen die Ordnungssegmente 11 lösbar miteinander verkettet sind. Das Ordnungsmittel 108 kann in vorgebbaren Längen von beispielsweise etwa 1 m oder 2 m hergestellt sein oder auch endlos hergestellt sein.

Jedes Ordnungssegment 11 weist einen stegförmigen Festlegeabschnitt 12 auf, der in eine an den Längsrändern des Montagesteges 3 angeordnete und eine Nut 13 (Fig. 7) aufweisende Aufnahmeeinrichtung 20 einsteckbar ist. Mittig in Bezug auf die Längserstreckung ist in den Festlegeabschnitt 12 eine in Einsteckrichtung verlaufende Nut 14 eingebracht, deren eine Werkzeugangriffsfläche bildendes Ende auch im eingesteckten Zustand zugänglich bleibt und in welche ein Werkzeug 33 (Fig. 4) zum Lösen des Ordnungssegments 11 einführbar ist.

Einstückig mit dem Festlegeabschnitt 12 bildet das Ordnungssegment 11 vorzugsweise federelastisch auslenkbare Ordnungselemente 15 aus, zwischen denen Verbindungsleitungen 34, 35 der Einrichtung 2 einsteckbar und dadurch geordnet fixierbar sind. Solltrennstellen 16, an denen die Ordnungssegmente 11 vereinzelt werden können, sind durch Einschnitte in den Festlegeabschnitt 12 gebildet. Die Einschnitte ragen dabei über eine von dem Ordnungssegment 11 gebildete Anschlagkante 17 hinaus, bis zu welcher das Ordnungssegment 11 in die Nut 13 einsteckbar ist. Dadurch ist die Position der Solltrennstelle 16 auch im eingesteckten Zustand sichtbar. Ein Trennschnitt kann aus Richtung der Ordnungselemente 15 erfolgen.

Das Ordnungssegment 9 weist zwei sich jeweils über die halbe Länge des Ordnungssegments 9 erstreckende Aufnahmekammern 18 für die zu ordnenden Verbindungsleitungen 34, 35 auf. Zwei dem Montagesteg 3 bzw. dem Festlegeabschnitt 12 gegenüberliegende Schenkel 19 des Ordnungssegments 9 sind federelastisch auslenkbar zum Einführen der zu ordnenden Verbindungsleitungen 34, 35 in die Aufnahmekammer 18. Demgegenüber weist das Ordnungssegment 7 eine Vielzahl, im Ausführungsbeispiel fünf Ordnungselemente 115 auf, die jeweils einen elastisch verformbaren Hakenabschnitt zum Verschließen der Aufnahmekammer 118 aufweisen. Weitere Ordnungssegmente können auch unterschiedlich ausgestaltete Aufnahmekammern 18, 118 aufweisen, insbesondere unterschiedlich große Aufnahmekammern 18, 118, beispielsweise eine oder mehrere größere Aufnahmekammern 18 identisch oder ähnlich wie das Ordnungssegment 9 und eine oder mehrere kleinere Aufnahmekammern 118 identisch oder ähnlich wie das Ordnungssegment 7. In einer Ausführungsart beträgt die Längserstreckung der einzelnen Aufnahmekammern 18, 118 mindestens 5 %, insbesondere mindestens 8 % und vorzugsweise mindestens 10 % der gesamten Längserstreckung des Ordnungssegments 7, 9. Bei der weiteren Komponente 10 des Montagesystems 1 handelt es sich um ein Kantenschutzelement. Die Ordnungssegmente 7, 9 weisen ebenso wie die weitere Komponente 10 eine übereinstimmende Länge von im Ausführungsbeispiel 50 mm auf.

Die Fig. 4 zeigt eine perspektivische Ansicht auf einen Montagesteg 103 mit einem durch ein Aneinanderreihen von Ordnungssegmenten 11 gebildeten und in die Nut 13 eingesetzten Ordnungsmittel 108. Ein Ordnungssegment 11 wurde dabei durch zwei Schnitte an den Sollbruchstellen 16 vereinzelt und durch Einsetzen eines Werkzeuges 33, beispielsweise der Klinge eines Schlitz-Schraubendrehers, kann das vereinzelte Ordnungssegment 11 gelöst und von dem Montagesteg 103 entnommen werden.

Die Fig. 5 zeigt eine perspektivische Ansicht auf den Montagesteg 103 der Fig. 4, wobei anstelle des in der Fig. 4 gelösten Ordnungssegments 11 ein Ordnungssegment 9 mit zwei großen Aufnahmekammern 18 eingesetzt ist, in die ein Bündel von Verbindungsleitungen 34 bzw. eine Verbindungsleitung 35 mit großem Querschnitt eingesetzt sind.

Zur besseren Fixierung der Verbindungsleitungen 34, 35 weist das Ordnungssegment 9 einen quer zur Längsrichtung vorspringenden, insbesondere auf die Vorderseite des Montagesteges 103 mit der Tragschiene 6 vorspringenden Halteabschnitt 36 auf. Das Ordnungssegment 9 weist für jede Aufnahmekammer 18 einen Halteabschnitt 36 auf. Der Halteabschnitt 36 ist an seinem freien Ende T-förmig ausgebildet zur besseren Fixierung eines Haltemittels 37, bei dem es sich um einen Kabelbinder handeln kann.

Die Figuren 6, 9 und 12 zeigen die Ordnungssegmente 7, 9 sowie die weitere Komponente 10 in einer Ansicht. Das Ordnungssegment 9 und die weitere Komponente 10 sind unlösbar an dem Montagesteg 3 festlegbar, weshalb diese Komponenten 9, 10 keine Werkzeugangriffsfläche 14 aufweisen.

Die Fig. 7 zeigt einen Schnitt durch einen Montagesteg 103 mit einem daran festgelegten Ordnungssegment 7. Die Fig. 8 zeigt in vergrößerter Darstellung einen Ausschnitt aus der Fig. 7 im Bereich der Verbindung des Ordnungssegments 7 mit dem Montagesteg 103. Die sich entlang der Längsachse des Montagesteges 103 erstreckende und einstückig von dem Montagesteg 103 ausgebildete Aufnahmeeinrichtung 20, in welche das Ordnungssegment 7 einsteckbar ist, weist neben der Nut 13, deren Seitenwände mehrere sich in Längsrichtung des Montagesteges 103 erstreckende weitere Nuten 21 oder Riffelungen aufweisen, auf einer Außenseite der Aufnahmeeinrichtung 20 zwei Rastflanken 22, 23 auf, die sich in Längsrichtung des Montagesteges 103 erstrecken und einstückig von diesem ausgebildet sind. Insbesondere sind die beiden Rastmittel 22, 23 auf einer Außenseite einer die Nut 13 begrenzenden Wand 24 gebildet, die in lateraler Richtung gegenüber der gegenüberliegenden und die Nut 13 ebenfalls begrenzenden Wand 25 zurückversetzt ist. Auf der Außenseite weist die Wand 24 eine schräg zur Einsteckrichtung des Ordnungssegments 7 und insbesondere schräg zur Nut 13 verlaufende Fläche auf. Durch die Schrägstellung ist ein Auslenken des Rastmittels 26 beim Einstecken des Ordnungssegments 7 mit geringer Einsteckkraft möglich.

Das Ordnungssegment 7, das eine Komponente erster Art des Montagesystems 1 bildet, weist ein zugehöriges Rastmittel 26 auf, das durch einen im unverformten Ausgangszustand nahezu parallel zu dem Festlegeabschnitt 12 verlaufenden, aber diesem gegenüber federelastisch auslenkbaren Schenkel gebildet ist, nahe dessen freiem Ende eine Rastflanke 27 erster Art gebildet ist, die mit der Richtung 28 der Zugkraft einen Winkel 29 von mehr als 90° einschließt, und dadurch das Verrasten allein durch Zugkraft lösbar ist. Zur vereinfachten Handhabung kann die Lösekraft durch einen in die Werkzeugangriffsfläche 14 einsteckbaren Schlitz-Schraubendreher 33 aufgebracht werden.

Die Fig. 10 zeigt einen Schnitt durch einen Montagesteg 103 mit einem daran festgelegten Ordnungssegment 9. Die Fig. 11 zeigt in vergrößerter Darstellung einen Ausschnitt aus der Fig. 10 im Bereich der Verbindung des Ordnungssegments 9 mit dem Montagesteg 103. Das Ordnungselement 9 bildet eine Komponente zweiter Art des Montagesystems 1 mit einem zugehörigen Rastmittel 126, das eine Rastflanke 30 zweiter Art aufweist, die mit der Richtung 28 der Zugkraft einen Winkel von weniger als 90° einschließt und dadurch das Verrasten allein durch Zugkraft nicht lösbar ist, sondern selbsthemmend ist. Dementsprechend ist das Ordnungselement 9 mit hoher Festigkeit an dem Montagesteg 3 festgelegt, entsprechend den großen Aufnahmekammern 18 für das Einbringen großer und schwerer Verbindungsleitungen 34, 35.

Die Fig. 13 zeigt einen Schnitt durch einen Montagesteg 103 mit einer daran festgelegten weiteren Komponente 10. Die Fig. 14 zeigt in vergrößerter Darstellung einen Ausschnitt aus der Fig. 13 im Bereich der Verbindung der weiteren Komponente 10 mit dem Montagesteg 103. Bei der weiteren Komponente 10 handelt es sich um ein Kantenschutzelement, das auf seiner von dem Montagesteg 103 wegweisenden Oberfläche eine sich über einen Winkelbereich von 180° erstreckende konvexe, aber von der Kreisform abweichende Oberfläche 32 aufweist. Die weitere Komponente 10 kann beispielsweise als Extrusionsteil aus einem Kunststoff hergestellt sein und individuell auf die gewünschte Länge abgelängt sein. Die weitere Komponente 10 weist keine Werkzeugangriffsfläche 14 auf, so dass eine Lösbarkeit der Verrastung durch eine Zugkraft in Richtung 28 zwar grundsätzlich möglich ist, aber aufgrund des verwendeten Werkstoffes und der konstruktiven Ausgestaltung manuell nicht oder nur mit großem Kraftaufwand möglich ist. Dies soll verhindern, dass die weitere Komponente 10 versehentlich von dem Montagesteg 103 gelöst werden kann.

In einer Ausführungsart ist bei jenen Ordnungssegmenten 7, 11 oder Komponenten, bei welchen in dem am Montagesteg 3, 103 festgelegten Zustand die Werkzeugangriffsfläche 14 sichtbar ist, das Verrasten nicht-selbsthemmend sondern allein durch Zugkraft lösbar, insbesondere weisen jene Ordnungssegmente 7, 11 ein Rastmittel 26 mit einer Rastflanke 27 erster Art auf, durch die das Verrasten allein durch Zugkraft lösbar ist.

Die Fig. 15 und 16 zeigen eine Seitenansicht auf einen Montagesteg 203 nach dem Stand der Technik bzw. auf eine Schalttafel 303 nach dem Stand der Technik, die jeweils eine Tragschiene 6 mit einer Höhe von beispielsweise 7,5 mm aufweisen. Bedingt durch die relativ geringe Höhe der Tragschiene 6 sind Einrichtungen 2 mit einer vergleichsweise großen Bauhöhe nicht festlegbar, sondern allenfalls Einrichtungen 102, die zumindest einseitig eine reduzierte Bauhöhe aufweisen. Um das Problem zu lösen, auch bei Tragschienen 6 mit einer vergleichsweise geringen Bauhöhe große Einrichtungen 2 festlegen zu können, weist ein vorzugsweise symmetrisch zu einer Mittelebene 40 aufgebauter Montagesteg 3 neben einem ersten vorzugsweise mittigen Abschnitt 41, in dem auch die Tragschiene 6 ausgebildet ist, einen von der Tragschiene 6 beabstandeten dritten Abschnitt 43 auf, der einen größeren Höhenabstand 44 von dem Fußpunkt 39 der Tragschiene 6 aufweist als ein zwischen dem ersten Abschnitt 41 und dritten Abschnitt 43 angeordneter zweiter Abschnitt 42 an seinem der Tragschiene 6 nahen, insbesondere an seinem an die Tragschiene 6 angrenzende Ende.

Im Beispiel der Fig. 17 und 18 wird dies durch eine konvexe Krümmung des Montagesteges 3 insbesondere in seinem zweiten Abschnitt 42 erreicht. Die konvexe Krümmung erstreckt sich über einen Winkelbereich von etwa 15°, und der Radius der konvexen Krümmung beträgt etwa das Vierfache der lateralen Erstreckung des gekrümmten zweiten Abschnitts 42. Der Höhenabstand 44 zwischen einem dem dritten Abschnitt 43 zugewandten Ende des zweiten Abschnitts 42 und einem dem ersten Abschnitt 41 zugewandten Ende des zweiten Abschnitts 42 entspricht dabei ungefähr der Höhe 45 der Tragschiene 6, so dass die Gesamthöhe 46 für das Anbringen der Einrichtung 2 an der Tragschiene 6 etwa das Doppelte der Höhe 45 der Tragschiene 6 beträgt. Wie die Figuren 17 und 18 zeigen, sind trotz der relativ geringen Höhe 45 der Tragschiene 6 problemlos Einrichtungen 2 mit großer Bauform an dem Montagesteg 3 festlegbar.

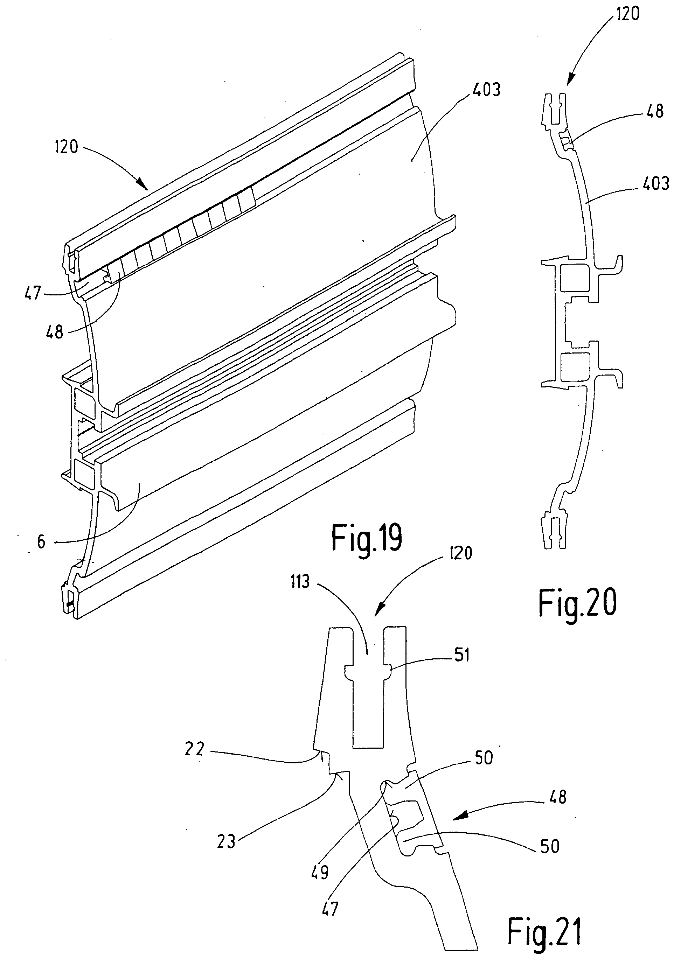

Die Fig. 19 zeigt eine perspektivische Ansicht auf einen Montagesteg 403. Die Fig. 20 zeigt eine Seitenansicht auf den Montagesteg 403 der Fig. 19. Die Fig. 21 zeigt einen Ausschnitt aus der Fig. 20 in vergrößerter Darstellung im Bereich einer von dem Montagesteg 403 einstückig ausgebildeten Nut 47 zum lösbar rastenden Einsetzen von Bezeichnungsschildern 48. Die Nut 47 weist dabei beidseitig einen Hinterschnitt 49 auf, in den jeweils ein federelastisch auslenkbarer Schenkel 50 des Bezeichnungsschilds 48 rastend eingreift. Die Nut 47 ist im Bereich des dritten Abschnitts 43 des Montagesteges 403 angeordnet oder in einem vom ersten Abschnitt 41 fernen Ende des zweiten Abschnitts 42 des Montagesteges 403. Dadurch ist gewährleistet, dass auch bei an dem Montagesteg 403 festgelegter Einrichtung 2 das Bezeichnungsschild 48 ablesbar ist. Das Bezeichnungsschild 48 kann beispielsweise eine Verbindungsleitung 35, 36 kennzeichnen, die benachbart zu dem Bezeichnungsschild 48 von der Rückseite auf die Vorderseite des Montagesteges 403 geführt ist, oder eine im Bereich des Bezeichnungsschilds 48 an der Tragschiene angeordnete Einrichtung 2.

In die Aufnahmeeinrichtung 120 sind Ordnungsmittel 8 oder sonstige Komponenten 10 des Montagesystems 1 einsetzbar, insbesondere in die Einstecknut 113 einsteckbar. Mindestens eine der Wände, welche die Einstecknut 113 begrenzen, weist eine oder mehrere, sich vorzugsweise in Längsrichtung der Einstecknut 113 erstreckende Vertiefungen 51 oder Riffelungen auf, beispielsweise zum unlösbaren Verrasten einer in die Aufnahmeeinrichtung 120 einsetzbaren bzw. in die Einstecknut 113 einsteckbaren Komponente des Montagesystems 1. Außenseitig weist auch die Aufnahmeeinrichtung 120 eine erste Rastflanke 22 und eine zweite Rastflanke 23 auf, wobei die erste nicht hemmende Rastflanke 22 einen geringeren Abstand von dem freien Ende der Aufnahmeeinrichtung 120 aufweist gegenüber der hemmenden zweiten Rastflanke 23.

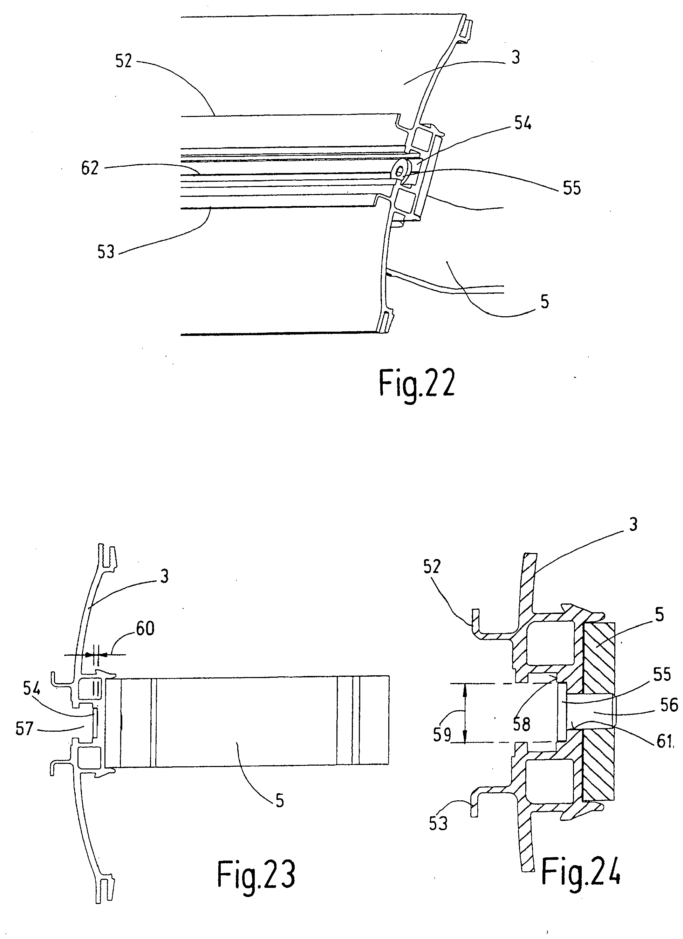

Die Fig. 22 zeigt eine perspektivische Ansicht auf ein Ende des Montagesteges 3 mit der Verbindung mit dem Montagebügel 5. Die Fig. 23 zeigt eine Seitenansicht auf den Montagesteg 3 der Fig. 22, und die Fig. 24 zeigt einen Ausschnitt der Fig. 23 in vergrößerter Darstellung im Bereich der Verbindung zwischen Montagesteg 3 und Montagebügel 5. Der Montagesteg 3 weist zwischen den beiden Tragschenkeln 52, 53 der Tragschiene 6 eine in Längsrichtung des Montagesteges 3 und vorzugsweise mittig verlaufende Nut 54 auf, die einen Kopf 55 eines Verbindungsmittels 56, insbesondere den Kopf einer Flachkopfschraube aufnimmt. Dadurch ragt der Kopf 55 in einem den Montagesteg 3 mit dem Montagebügel 5 verbundenen Zustand nicht in den Bereich zwischen den beiden Tragschenkeln 52, 53 hinein und behindert dadurch nicht das Anbringen der Einrichtung 2.

Im Beispiel weist der Montagesteg 3 zwischen den beiden Tragschenkeln 52, 53 einen in Längsrichtung des Montagesteges 3 verlaufenden Gleitmutterkanal 57 auf. Die Nut 54 ist in die Bodenfläche 58 des Gleitmutterkanals 57 eingebracht. Der Kopf 55 des Verbindungsmittels 56 ragt im verbundenen Zustand nicht über die Bodenfläche 58 des Gleitmutterkanals 57 hinaus bzw. nicht in den Gleitmutterkanal 57 hinein. Dadurch ist auch bei montiertem Verbindungsmittel 56 das Einbringen einer oder mehrerer Gleitmuttern in den Gleitmutterkanal 57 möglich, insbesondere auch in einen beidseitig von Verbindungsmitteln 56 begrenzten Abschnitt des Gleitmutterkanals 57.

Die Breite 59 der Nut 54 ist weniger als 50 % größer als die Breite des Kopfes 55 des Verbindungsmittels 56, insbesondere weniger als 25 % und vorzugsweise weniger als 10 %. Die Tiefe 60 der Nut 54 ist weniger als 50 % größer als die Höhe des Kopfes 55 des Verbindungsmittels 56, insbesondere weniger als 25 % und vorzugsweise weniger als 10 %. Die Breite 59 der Nut 54 beträgt weniger als 90 % der Breite des Gleitmutterkanals 57, insbesondere weniger als 80 % und im Ausführungsbeispiels etwa 75 %. Die Breite 59 der Nut 54 entspricht etwa der Breite der den Tragschenkeln 52, 53 zugewandten Öffnung des Gleitmutterkanals 57. Die Tiefe 60 der Nut 54 beträgt weniger als 150 % der Tiefe des Gleitmutterkanals 57, insbesondere weniger als 100 % und vorzugsweise weniger als 50 %.

Das Verbindungsmittel 56 ist im Beispiel eine Flachkopfschraube, die in eine Durchgangsbohrung 61 im Montagesteg 3 eingesetzt ist und in eine Gewindebohrung des Montagebügels 5 eingeschraubt ist. Die Durchgangsbohrung 61 kann wahlfrei an einer für die Verbindung des Montagesteges 3 mit dem Montagebügel 5 geeigneten Stelle in den Montagesteg 3 eingebracht werden. Hierzu weist der Montagesteg 3 als Zentrierhilfe eine mittig in der Bodenfläche der Nut 54 eingebrachte, sich in Längsrichtung des Montagesteges 3 erstreckende und vorzugsweise V-förmige Rinne 62 auf.

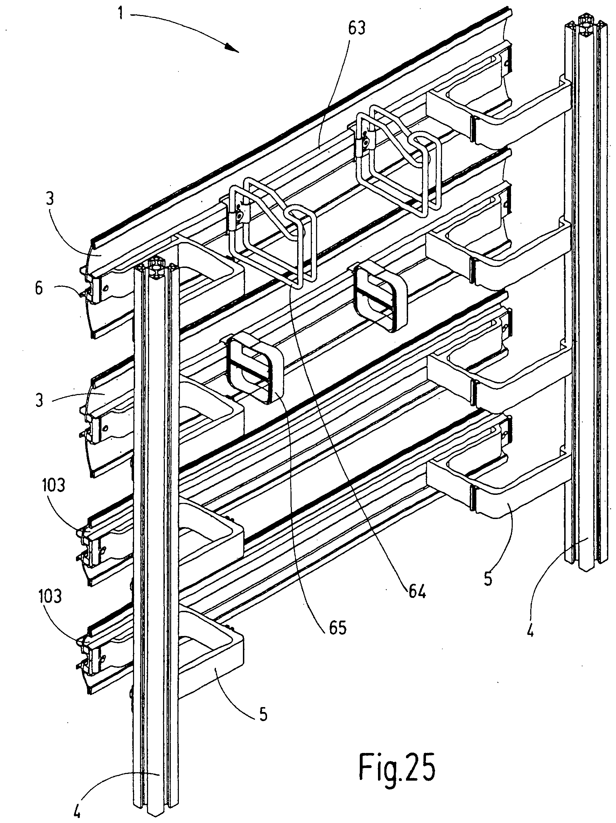

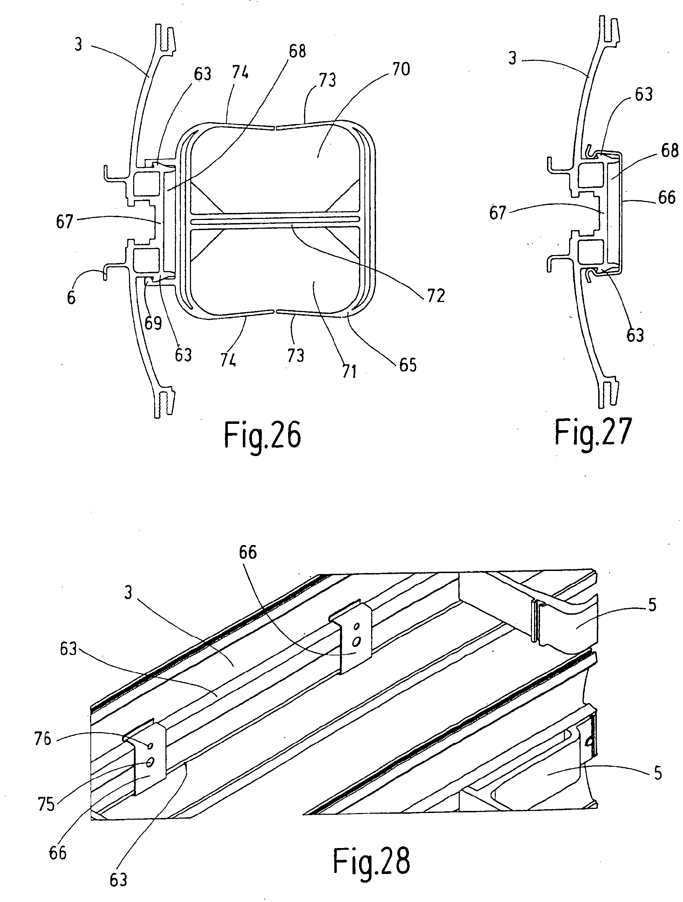

Die Fig. 25 zeigt eine perspektivische Ansicht auf die Rückseite des Montagesystems 1 der Fig. 1. Der Montagesteg 3 weist auf seiner der Tragschiene 6 gegenüberliegenden Rückseite mindestens einen sich in Längsrichtung des Montagesteges 3 erstreckenden Raststeg 63 auf, auf den weitere Komponenten 64, 65 des Montagesystems 1 unmittelbar aufrastbar sind oder mittelbar unter Verwendung eines aufrastbaren Adapterelements 66 (Fig. 27) festlegbar sind.

Die Fig. 26 zeigt eine Seitenansicht auf den Montagesteg 3 der Fig. 25. Der Montagesteg 3 weist in seinem mittleren Bereich auf der Rückseite zwei parallel verlaufende Raststege 63 auf, deren freie Enden gegenüber einem Verbindungssteg 67 vorspringen und dadurch eine Nut 68 bzw. einen Aufnahmeraum begrenzen, in den beispielsweise entweder der Montagebügel 5 eingelegt werden kann oder ein Verbindungselement eingreifen kann, beispielsweise ein Verbindungselement zum Verbinden einer weiteren Komponente 64 mit dem Adapterelement 66. Die Raststege 63 sind einstückig vom Montagesteg 3 ausgebildet.

Die Raststege 63 weisen eine selbsthemmende Rastkante 80 (Fig. 32) auf, insbesondere eine Rastkante 80 mit Hinterschnitt 81. Die beiden Raststege 63 verlaufen voneinander beabstandet aber parallel zueinander im Bereich der auf der Vorderseite angeordneten Tragschiene 6. Auf die Raststege 63 ist eine erste weitere Komponente 65 zum Bündeln von auf der Rückseite des Montagesteges 3 verlaufenden Verbindungsleitungen 34, 35 der auf der Vorderseite angeordneten Einrichtung 2 aufgerastet, die neben einem auf die Raststege 3 aufrastbaren Verbindungsabschnitt 69 auch zwei Bündelkammern 70, 71 aufweist für die Aufnahme von Verbindungsleitungen 34, 35. Die Bündelkammern 70, 71 sind symmetrisch zu einer Mittelebene, ebenso wie die doppelwandige Trennwand 72. Die beiden Bündelkammern 70, 71 sind jeweils über zwei federelastisch auslenkbare Schenkel 73, 74 von außen zugänglich, wobei die Schenkel 73, 74 auf einander gegenüberliegenden und an den Verbindungsabschnitt 69 angrenzenden Seiten angeordnet sind.

Die Fig. 27 zeigt eine Seitenansicht auf einen Montagesteg 3 mit einem auf die Raststege 63 aufgerasteten Adapterelement 66. Die Fig. 28 zeigt eine perspektivische Ansicht auf die Rückseite des Montagesteges 3 mit zwei aufgerasteten Adapterelementen 66. Das Adapterelement 66 weist eine vorzugsweise mittig angeordnete Bohrung 75 auf, die als Gewindebohrung ausgeführt sein kann oder ein angerolltes Gewinde, einen Gewindedurchzug, eine Einpressmutter oder dergleichen aufweisen kann, und eine oder mehrere, vorzugsweise exzentrisch angeordnete weitere Bohrungen 76 auf, die eine mechanische Schnittstelle für das Anbringen weiterer Komponenten des Montagesystems 1 auf der Rückseite des Montagesteges 3 bilden können. Die weitere Bohrung 76 kann beispielsweise ein Positioniermittel für das Anbringen weiterer Komponenten bilden, beispielsweise zum Einsetzen eines zugehörigen Positioniermittels der weiteren Komponente. Die Bohrungen 75, 76 korrespondieren mit dem durch das Adapterelement 66, die beiden Raststege 63 und den Verbindungssteg 67 begrenzten Aufnahmeraum 68.

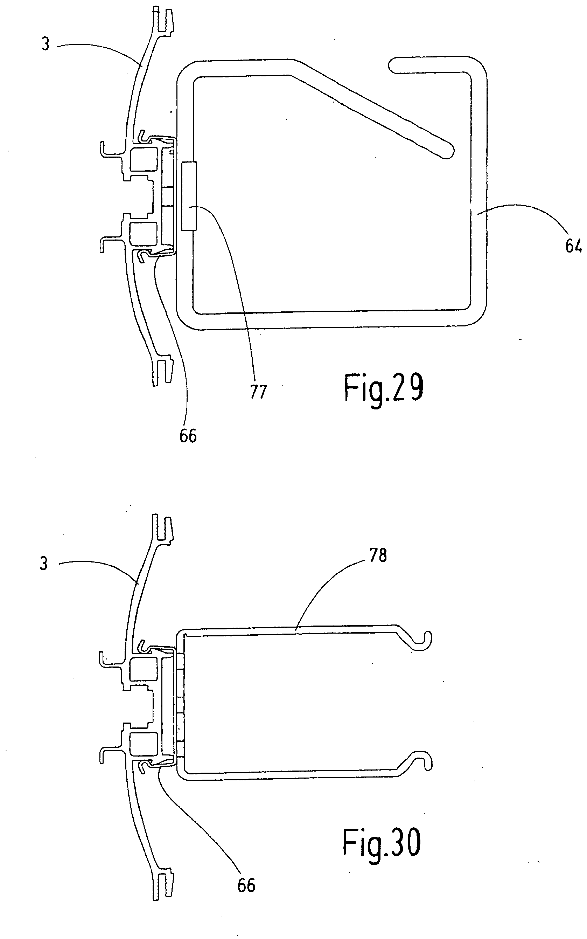

Die Fig. 29 zeigt eine zweite weitere Komponente 64 des Montagesystems 1, bei der es sich um ein weiteres Bündelelement zum Bündeln von Versorgungsleitungen 34, 35 handelt. Die zweite weitere Komponente 64 ist ein zweispuriges Drahtbiegeteil, das mittels eines mit dem Adapterelement 66 verschraubten Befestigungselements 77 klemmend an dem Adapterelement 66 festgelegt ist. Durch teilweises Lösen des Befestigungselements 77 wird die zweite weitere Komponente 64 zwar noch gehalten, ist aber gegenüber dem Adapterelement 66 entlang der beiden parallel zueinander verlaufenden Drahtspuren bewegbar und anschließend wieder klemmbar, so dass die gewünschte Position der zweiten weiteren Komponente 64 in Bezug auf das an den Raststegen 63 fixierte Adapterelement 66 bzw. den Montagesteg 3 einstellbar ist.

Die Fig. 30 zeigt eine Seitenansicht des Montagesteges 3 mit einem auf der Rückseite mittels des Adapterelements 66 auf den Montagesteg 3 aufgerasteten Kabelkanal 78.

Die Fig. 31 zeigt eine perspektivische Ansicht auf ein weiteres Beispiel eines Montagesystems 101, bei dem mindestens ein Montagesteg 403 an oder nahe seinen beiden Enden über ein Verbindungselement 79 mit jeweils einem vertikal verlaufenden Profilstab 4 verbunden ist. Das Verbindungselement 79 ist dabei aus einem Abschnitt eines Profils gebildet, aus dem auch der Profilstab 4 hergestellt ist. Alternativ kann auch ein sonstiges Distanzstück verwendet werden, beispielsweise ein Profilstück mit kleineren Querschnittsabmessungen oder auch eine auf den gewünschten Abstand des Montagesteges 403 von dem Profilstab 4 abgelängte Stange. Der Kopf 55 der Schraube, mittels welcher der Montagesteg 403 mit dem Verbindungselement 79 verbunden ist, liegt versenkt in der Nut 54 im Gleitmutterkanal 57.

Die Fig. 32 zeigt eine Seitenansicht auf ein weiteres Beispiel eines Montagesteges 503, der mittels eines Verbindungselements 79 an einem Profilstab 4 festlegbar ist. Das im Querschnitt vorzugsweise quadratische Verbindungselement 79 weist eine Kantenlänge auf, die dem Abstand der beiden Raststege 63 entspricht oder geringfügig kleiner ist, so dass die Raststege 63 durch einen Formschluss eine Führung beim Einsetzen des Verbindungselements 79 in den durch die Raststege 63 begrenzten Aufnahmeraum 68 (Fig. 27) bilden. Auch wenn anstelle des Verbindungselements 79 ein sonstiges Distanzstück verwendet wird, ist es vorteilhaft, wenn auch dieses einen Formschluss mit den Raststegen 63 aufweist, beispielsweise im Fall einer im Querschnitt runden oder verrundete Ecken aufweisenden Distanzstange, wenn diese mindestens an ihrem dem Montagesteg 503 zugewandten Endabschnitt zwei einander gegenüberliegende abgeflachte Seiten aufweist, deren Abstand dem Abstand der Raststege 63 entspricht.

Der Montagesteg 503 weist ebenso wie die zuvor beschriebenen Ausführungsbeispiele eine Aufnahmeeinrichtung 120 für Ordnungsmittel 8 oder weitere Komponenten 10 sowie einen Gleitmutterkanal 57 mit Nut 54 auf, aber der Montagesteg 503 weist keine Tragschiene 6 auf. Vielmehr werden die Einrichtungen 2 mittels Schrauben an dem Montagesteg 503 festgelegt, die mit im Gleitmutterkanal 57 angeordneten und dort verschiebbaren Muttern verschraubbar sind. Die nach beiden Seiten an den Gleitmutterkanal 57 anschließenden Abschnitte des Montagesteges 503 sind plan, beispielsweise für eine großflächige Anlage der festzulegenden Einrichtung 2. Die dem Gleitmutterkanal 57 abgewandten Enden der planen Abschnitte sind rechtwinklig abgebogen und bilden abschließend jeweils eine Aufnahmeeinrichtung 120 aus, die gegenüber der durch die planen Abschnitte bestimmten Ebene zurückversetzt sind.

Die Fig. 33 zeigt eine Seitenansicht auf ein weiteres Beispiel eines Montagesteges 603, der mittels eines Verbindungselements 79 an einem Profilstab 4 festlegbar ist. Der Montagesteg 603 weist auf seiner Vorderseite eine konvexe Krümmung auf, an deren Position größter Vorwölbung eine Tragschiene 6 angeordnet ist. Während die Tragschiene 6 und auch der Gleitmutterkanal 57 mit der Nut 54 symmetrisch zu einer Mittelebene 40 sind, ist das Profil des Montagesteges 603 unsymmetrisch zu dieser Mittelebene 40. Der auf der einen Seite an die Tragschiene 6 anschließende und an der Aufnahmeeinrichtung 120 endende zweite Abschnitt 142 weist in lateraler Richtung eine größere Erstreckung auf als der auf der anderen Seite an die Tragschiene 6 anschließende zweite Abschnitt 242. Demgegenüber ist der Höhenabstand 44, den die beiden zweiten Abschnitte 142, 242 überstreichen, übereinstimmend.

## Patentansprüche

1. Montagesystem (1) für die Anordnung von, beispielsweise elektrischen, Einrichtungen (2) insbesondere in Schaltschränken, wobei das Montagesystem (1) mindestens einen vorzugsweise horizontal verlaufenden Montagesteg (3) aufweist, an dem mindestens eine Einrichtung (2) anbringbar ist, wobei das Montagesystem (1) ein mit dem Montagesteg (3) verbindbares Ordnungsmittel (8) aufweist zum Ordnen der Verbindungsleitungen (34, 35) der an dem Montagesteg (3) anzubringenden Einrichtung (2), wobei das Ordnungsmittel (8) eine entlang der Längsrichtung des Montagesteges (3) mit dem Montagesteg verbindbare Vielzahl miteinander verbundener oder aneinander anliegender Ordnungssegmente (7, 9, 11) aufweist, und wobei aus dem Ordnungsmittel (8) wahlweise einzelne oder mehrere Ordnungssegmente (7, 9, 11) lösbar und von dem Ordnungsmittel (8) unter Zurücklassen einer Lücke in dem Ordnungsmittel (8) entfernbar oder gegen ein anderes Ordnungssegment (7, 9, 11) austauschbar sind, **dadurch gekennzeichnet, dass** das Montagesystem (1) unterschiedliche Ordnungssegmente (7, 9, 11) für unterschiedliche Abmessungen der zu ordnenden Verbindungsleitungen aufweist, wobei die unterschiedlichen Ordnungssegmente (7, 9, 11) vorzugsweise eine übereinstimmende Länge aufweisen, und dass die unterschiedlichen Ordnungssegmente (7, 9, 11) entlang des Montagesteges (3) wahlfrei aneinander anreihbar sind.

2. Montagesystem (1) nach Anspruch 1, **dadurch gekennzeichnet, dass** die Ordnungssegmente (7, 9, 11) an beiden Enden Verkettungsmittel aufweisen, mittels denen ein Ordnungssegment (7, 9, 11) mit einem daran in Längsrichtung anschließenden weiteren Ordnungssegment (7, 9, 11) verkettbar ist.

3. Montagesystem (1) nach Anspruch 2, **dadurch gekennzeichnet, dass** die Verkettung lösbar ist, insbesondere durch eine Relativbewegung der beiden miteinander verketteten Ordnungssegmente (7, 9, 11) schräg und insbesondere quer zur Längsrichtung der Ordnungssegmente (7, 9, 11) lösbar ist.

4. Montagesystem (1) nach einem der vorangehenden Ansprüche, **dadurch gekennzeichnet, dass** das Ordnungsmittel (8) in einem Ausgangszustand die aneinander angereihten Ordnungssegmente (7, 9, 11) einstückig ausbildet, und dass das Ordnungsmittel (8), vorzugsweise äquidistante, die einzelnen Ordnungssegmente (7, 9, 11) begrenzende Solltrennstellen (16) aufweist.

5. Montagesystem (1) nach Anspruch 4, **dadurch gekennzeichnet, dass** die Solltrennstelle (16) in einem Festlegeabschnitt (12) des Ordnungsmittels (8) angeordnet ist, mittels dem das Ordnungsmittel (8) an dem Montagesteg (3) festlegbar ist.

6. Montagesystem (1) nach einem der vorangehenden Ansprüche, **dadurch gekennzeichnet, dass** die Ordnungssegmente (7, 9, 11) vorzugsweise mittig in Bezug auf ihre Längserstreckung eine Werkzeugangriffsfläche (14) aufweisen, an der ein Werkzeug (33) zum Lösen eines mit dem Montagesteg (3) verbundenen Ordnungssegments (7, 9, 11) ansetzbar ist.

7. Montagesystem (1) nach einem der vorangehenden Ansprüche, **dadurch gekennzeichnet, dass** ein Ordnungssegment (7, 9, 11) eine sich vorzugsweise über die gesamte Länge des Ordnungssegments (7, 9, 11) erstreckende Aufnahmekammer (18) für die zu ordnende Verbindungsleitung (34, 35) bildet, und dass ein dem Montagesteg (3) gegenüberliegender Schenkel (19) des Ordnungssegments (7, 9, 11) auslenkbar ist und dadurch die zu ordnende Verbindungsleitung (34, 35) in die Aufnahmekammer (18) einführbar ist.

8. Montagesystem (1) nach einem der vorangehenden Ansprüche, **dadurch gekennzeichnet, dass** das Ordnungssegment (7, 9, 11) einen schräg und insbesondere quer zur Längsrichtung des Ordnungssegments (7, 9, 11) vorspringenden Halteabschnitt (36) aufweist zum Anbringen eines Haltemittels (37), beispielsweise eines Kabelbinders, für die zu ordnende Verbindungsleitung (34, 35).

9. Montagesystem (1) nach einem der vorangehenden Ansprüche, **dadurch gekennzeichnet, dass** mindestens ein Teil der Ordnungssegmente (7, 9, 11) eine Länge von weniger als 150 mm aufweist, insbesondere weniger als 100 mm und vorzugsweise weniger als 80 mm.

## Claims

1. A mounting system (1) for arranging for example electric devices (2), in particular in electrical enclosures, wherein the mounting system (1) has at least one preferably horizontal mounting strip (3) to which at least one device (2) can be secured, wherein the mounting system (1) has an ordering means (8) which can be connected to the mounting strip (3) for ordering the connecting lines (34, 35) of the device (2) to be secured to the mounting strip (3), wherein the ordering means (8) has a plurality of ordering segments (7, 9, 11) which can be interconnected or resting against one another along the longitudinal direction of the mounting strip (3), and wherein individual or several ordering segments (7, 9, 11) can be selectively detached from the ordering means (8) and be removed therefrom (8) so as to leave a gap in the ordering means (8) or be replaced by another ordering segment (7, 9, 11), **characterised in that** the mounting system (1) has different ordering segments (7, 9, 11) for different dimensions of the connecting lines to be ordered, wherein the different ordering segments (7, 9, 11) are preferably of equal length, and that the different ordering segments (7, 9, 11) can optionally be lined up next to each other along the mounting strip (3).

2. A mounting system (1) according to claim 1, **characterised in that** the ordering segments (7, 9, 11) have interlinking means at both ends thereof, by means of which an ordering segment (7, 9, 11) can be linked to an additional ordering segment (7, 9, 11) adjacent thereto in longitudinal direction.

3. A mounting system (1) according to claim 2, **characterised in that** the interlinking can be released, in particular by a relative movement of the two interlinked ordering segments (7, 9, 11) diagonally and in particular transversely to the longitudinal direction of the ordering segments (7, 9, 11).

4. A mounting system (1) according to one of the preceding claims, **characterised in that** the ordering means (8) in an initial state forms as a single piece the ordering segments (7, 9, 11) lined up next to one another, and that the ordering means (8) has preferably equidistant predetermined separation points (16) delimiting the individual ordering segments (7, 9, 11).

5. A mounting system (1) according to claim 4, **characterised in that** the predetermined separation point (16) is arranged in a fastening section (12) of the ordering means (8), by means of which the ordering means (8) can be fastened to the mounting strip (3).

6. A mounting system (1) according to one of the preceding claims, **characterised in that** the ordering segments (7, 9, 11) have a tool engagement surface (14) preferably in the centre, relative to the longitudinal extension thereof, on which a tool (33) can be placed in order to detach an ordering segment (7, 9, 11) connected to the mounting strip (3).

7. A mounting system (1) according to one of the preceding claims, **characterised in that** an ordering segment (7, 9, 11) forms a receiving channel (18) extending preferably over the entire length of the ordering segment (7, 9, 11) for the connecting line (34, 35) to be ordered, and that a leg (19) of the ordering segment (7, 9, 11) opposite the mounting strip (3) can be deflected, and thereby the connecting line (34, 35) to be ordered can be inserted into the receiving channel (18).

8. A mounting system (1) according to one of the preceding claims, **characterised in that** the ordering segment (7, 9, 11) has a holding section (36) protruding diagonally and in particular transversely to the longitudinal direction of the ordering segment (7, 9, 11), for attaching a holding means (37), for example a cable tie, for the connecting line (34, 35) to be ordered.

9. A mounting system (1) according to one of the preceding claims, **characterised in that** at least one portion of the ordering segments (7, 9, 11) has a length of less than 150 mm, in particular less than 100 mm, and preferably less than 80 mm.

## Revendications

1. Système (1) de montage pour l'agencement de dispositifs (2), par exemple électriques, notamment dans des armoires de commande, le système (1) de montage ayant au moins un longeron (3) de montage, qui s'étend, de préférence, horizontalement, et sur lequel peut être mis au moins un dispositif (2), le système (1) de montage ayant un moyen (8) d'ordonnancement, pouvant être relié au longeron (3) de montage, pour ordonner les lignes (34, 35) de liaison du dispositif (2) à mettre sur le longeron (3) de montage, le montage (8) d'ordonnancement ayant une pluralité, pouvant être reliée au longeron de montage le long de la direction longitudinale du longeron (3) de montage, de segments (7, 9, 11) d'ordonnancement reliés les uns aux autres ou s'appliquant les uns aux autres, et dans lequel, au choix, des segments (7, 9, 11) d'ordonnancement, individuels ou à plusieurs, peuvent être détachés du moyen (8) d'ordonnancement et retirés du moyen (8) d'ordonnancement en laissant un vide dans le moyen (8) d'ordonnancement ou être remplacés par un autre segment (7, 9, 11) d'ordonnancement, **caractérisé en ce que** le système (1) de montage a des segments (7, 9, 11) différents pour des dimensions différentes des lignes de liaison à ordonner, les segments (7, 9, 11) d'ordonnancement différents ayant, de préférence, une longueur concordante, et **en ce que** les segments (7, 9, 11) d'ordonnancement différents peuvent être rangés, au choix, les uns contre les autres suivant le longeron (3) de montage.

2. Système (1) de montage suivant la revendication 1, **caractérisé en ce que** les segments (7, 9, 11) d'ordonnancement ont, aux deux extrémités, des moyens d'enchaînement, au moyen desquels un segment (7, 9, 11) d'ordonnancement peut être enchaîné à un autre segment (7, 9, 11) d'ordonnancement s'y raccordant dans la direction longitudinale.

3. Système (1) de montage suivant la revendication 2, **caractérisé en ce que** l'enchaînement peut être défait, notamment par un déplacement relatif des deux segments (7, 9, 11) d'ordonnancement enchaînés l'un à l'autre, de manière inclinée et notamment transversalement à la direction longitudinale des segments (7, 9, 11) d'ordonnancement.

4. Système (1) de montage suivant l'une des revendications précédentes, **caractérisé en ce que** le moyen (8) d'ordonnancement constitue, dans un état initial, les segments (7, 9, 11) d'ordonnancement rangés les uns contre les autres d'une seule pièce et **en ce que** le moyen (8) d'ordonnancement a des points (16) destinés à se rompre, de préférence équidistants, délimitant les divers segments (7, 9, 11).

5. Système (1) de montage suivant la revendication 4, **caractérisé en ce que** le point (16) destiné à se rompre est disposé dans une partie (12) de fixation du moyen (8) d'ordonnancement, au moyen de laquelle le moyen (8) d'ordonnancement peut être fixé au longeron (3) de montage.

6. Système (1) de montage suivant l'une des revendications précédentes, **caractérisé en ce que** les segments (7, 9, 11) d'ordonnancement ont, de préférence au milieu par rapport à leur étendue longitudinale, une surface (14) d'attaque d'outil, sur laquelle un outil (33) peut être mis pour détacher un segment (7, 9, 11) d'ordonnancement relié au longeron (3) de montage.

7. Système (1) de montage suivant l'une des revendications précédentes, **caractérisé en ce qu'**un segment (7, 9, 11) d'ordonnancement forme une chambre (18), s'étendant de préférence sur toute la longueur des segments (7, 9, 11) d'ordonnancement, de réception de la ligne (34, 35) de liaison à ordonner et **en ce qu'**une branche (19), opposée au longeron (3) de montage, du segment (7, 9, 11) d'ordonnancement peut être déviée et ainsi la ligne (34, 35) de liaison à ordonner peut être introduite dans la chambre (18) de réception.

8. Système (1) de montage suivant l'une des revendications précédentes, **caractérisé en ce que** le segment (7, 9, 11) d'ordonnancement a une partie (36) de maintien, faisant saillie de façon inclinée et notamment transversalement à la direction longitudinale du segment (7, 9, 11) d'ordonnancement, pour le montage d'un moyen (37) de maintien, par exemple d'une bande-lieuse pour câble, de la ligne (34, 35) de liaison à ordonner.

9. Système (1) de montage suivant l'une des revendications précédentes, **caractérisé en ce qu'**au moins une partie des segments (7, 9, 11) d'ordonnancement a une longueur plus petite que 150 mm, notamment plus petite que 100 mm et, de préférence, plus petite que 80 mm.
